(19) **Europäisches Patentamt**

**European Patent Office**

**Office européen des brevets**

(11) **EP 1 294 024 A2**

(12) **EUROPÄISCHE PATENTANMELDUNG**

(43) Veröffentlichungstag:
**19.03.2003 Patentblatt 2003/12**

(51) Int Cl.⁷: **H01L 29/36**, H01L 29/08,
H01L 29/10

(21) Anmeldenummer: **02016117.0**

(22) Anmeldetag: **19.07.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(30) Priorität: **17.09.2001 DE 10145723**

(71) Anmelder: **Infineon Technologies AG**
**81669 München (DE)**

(72) Erfinder: **Gabl, Reinhard**
**80337 München (DE)**

(74) Vertreter: **Schoppe, Fritz, Dipl.-Ing. et al**
**Schoppe, Zimmermann, Stöckeler & Zinkler**
**Patentanwälte**
**Postfach 71 08 67**
**81458 München (DE)**

(54) **Halbleiterstruktur**

(57) Die vorliegende Erfindung schafft eine Halbleiterstruktur, die einen ersten Bereich (10) mit einem ersten Dotiertyp und einer ersten Dotierkonzentration und einen zweiten Bereich (12) mit einem zweiten Dotiertyp und einer zweiten Dotierkonzentration aufweist, wobei der zweite Dotiertyp zu dem ersten Dotiertyp unterschiedlich ist. Der zweite Bereich (12) ist so angeordnet, daß er an den ersten Bereich (10) angrenzt. Die Halbleiterstruktur umfaßt ferner einen dritten Bereich (16a-e) mit dem ersten Dotiertyp und einer dritten Dotierkonzentration, wobei der dritte Bereich (16a-e) innerhalb des zweiten Bereichs (12) angeordnet ist, so daß der dritte Bereich (16a-e) im wesentlichen vollständig in einer Raumladungszone in dem zweiten Bereich (12) angeordnet ist, die entsteht, wenn eine Betriebsspannung an die Halbleiterstruktur angelegt wird.

FIG 3A

EP 1 294 024 A2

**Beschreibung**

Die vorliegende Erfindung bezieht sich auf das Gebiet von Halbleiterstrukturen und spezieller auf das Gebiet von Halbleiterstrukturen mit einem p-n-Übergang.

Bei p-n-Übergängen und insbesondere Kollektor-Basis-Übergängen von Bipolartransistoren wird das Verhalten von mehreren Faktoren beeinflusst.

Ein erster beeinflussender Faktor ist der Lawinen-Durchbruch, bei dem Ladungsträger bei Überschreiten einer maximalen elektrischen Feldstärke aus dem elektrischen Feld genügend Energie aufnehmen, um neue Ladungsträger zu erzeugen. Dadurch kommt es zu einem lawinenartigen Ansteigen der Ladungsträgerzahl, die an dem Ort der höchsten Feldstärke einsetzt. Bei einem Halbleiterbauteil mit p-n-Übergang wird daher die maximale Betriebsspannung typischerweise durch eine Durchbruchsspannung des p-n-Übergangs, d.h. diejenige Spannung an dem Übergang, bei dem der Lawinendurchbruch gerade einsetzt, definiert.

Beispielsweise wird bei einem Bipolartransistor die maximale Betriebsspannung durch die Basis-Kollektor-Durchbruchsspannung begrenzt. Wie es nachfolgend noch näher erklärt wird, gilt, je niedriger die Dotierung des Kollektors ist desto höher ist die Durchbruchsspannung. Um eine möglichst große Basis-Kollektor-Durchbruchsspannung und folglich ein Arbeiten bei hohen Betriebsspannungen zu erreichen, ist es bei einem Entwerfen des Bipolartransistors notwendig, eine niedrige Dotierung des Kollektors vorzusehen.

Als ein weiterer Parameter wird das Verhalten von Bauelementen mit p-n-Übergängen durch die Stromtragfähigkeit des Bauelements bestimmt. Beispielsweise bestimmt bei einem Bipolartransistor die Stromtragfähigkeit des Kollektors das Auftreten des sogenannten Kirk-Effekts, bei dem es aufgrund von strombedingten Umladungseffekten im Kollektor zu einer Potentialverschiebung kommt. Das Auftreten des Kirk-Effekts begrenzt eine erreichbare Transitfrequenz bzw. maximale Oszillationsfrequenz des Bipolar-Transistors, wobei dieselbe durch die Kollektordotierung beeinflußt werden kann. Dabei gilt, je höher die Kollektordotierung ist, desto höher ist die maximale Transitfrequenz.

Folglich stehen die Durchbruchsspannung und die Stromtragfähigkeit eines p-n-Übergangs in Konkurrenz zueinander, so daß bei dem Entwerfen eines Bipolartransistors bei der Wahl der Kollektordotierung ein Kompromiß zwischen einer zu erreichenden Basis-Kollektor-Durchbruchsspannung und einer Stromtragfähigkeit des Kollektors eingegangen werden muß.

Bekannterweise wird bei einem Entwurf von Bauelementen mit p-n-Übergängen die Auswahl der Dotierungen je nach Einsatzgebiet des Bauelements ausgewählt. Beispielsweise wird bei Transistoren die Auswahl der Kollektordotierung in Abhängigkeit von der geplanten Anwendung des Transistors ausgewählt, wobei für Transistoren, bei denen hauptsächlich das Betreiben bei hohen elektrischen Spannungen im Vordergrund steht, eine niedrige Kollektordotierung gewählt wird.

Entsprechend gegensätzlich dazu, wird bei bekannten Transistoren, bei denen hauptsächlich das Erreichen einer hohen Transitfrequenz vorrangig ist, eine hohe Dotierstoffkonzentration des Kollektorbereichs gewählt.

Bei Bipolar-Leistungsbauelementen und insbesondere bei Hochfrequenz-Leistungstransistoren, die aufgrund von Betriebsspannungen in dem Bereich von typischerweise 28 V hohe Durchbruchsspannungen und folglich eine niedrige Dotierstoffdotierung des Kollektorbereichs erfordern, ergibt sich aufgrund der obigen Erklärungen dahingehend ein Problem, daß keine kurzen Transitzeiten von Ladungsträgern durch das Bipolar-Leistungsbauelement erreicht werden können.

Die Aufgabe der vorliegenden Erfindung besteht darin, ein Konzept zu schaffen, das ein verbessertes Verhalten von Bipolar-Halbleiterstrukturen ermöglicht.

Diese Aufgabe wird durch eine Halbleiterstruktur nach Anspruch 1 und Verfahren nach den Ansprüchen 12 und 13 gelöst.

Die vorliegende Erfindung basiert auf der Erkenntnis, daß bei einer bipolaren Halbleiterstruktur, die einen ersten Bereich mit einer ersten Dotierung und einen zweiten Bereich mit einer zweiten Dotierung umfaßt, die maximale elektrische Feldstärke, die in einem Raumladungsbereich auftritt, dadurch erniedrigt werden kann, daß in dem zweiten Bereich ein dritter Bereich mit einem Dotiertyp des ersten Bereichs vorgesehen ist. Der dritte Bereich ist in dem zweiten Bereich derart angeordnet, daß derselbe bei einer an die Halbleiterstruktur angelegten Betriebsspannung im wesentlichen in der Raumladungszone liegt, so daß der Transport der Ladungsträger im wesentlichen nicht beeinflußt ist.

Ein Vorteil der vorliegenden Erfindung besteht darin, daß die erfindungsgemäße Halbleiterstruktur sowohl mit einer hohen Betriebsspannung als auch mit einer hohen Transitfrequenz betrieben werden kann.

Bei einem Ausführungsbeispiel ist die Halbleiterstruktur eine Basis-Kollektor-Halbleiterstruktur eines NPN-Hochleistungs-Bipolar-Transistors, wobei in dem n-dotierten Kollektorbereich mehrere voneinander beabstandete p-dotierte Bereiche. mit einer hohen δ-Dotierung (δ-Dotierungs-Bereiche) vorgesehen sind.

Bevorzugte Ausführungsbeispiele der vorliegenden Erfindung werden nachfolgend unter Bezugnahme auf die beiliegenden Zeichnungen näher erläutert. Es zeigen:

Fig. 1     ein Schaubild zur Darstellung des typischen Verlaufs der Transitfrequenz abhängig von der Frequenz;

Fig. 2      ein Verlauf eines elektrischen Felds an einem Basis-Kollektor-Übergang bei einem bekannten Bipolar-Transistor;

Fig. 3a      ein Dotierstoff-Profil gemäß einem Ausführungsbeispiel der vorliegenden Erfindung;

Fig. 3b      ein Verlauf eines elektrischen Felds bei dem Ausführungsbeispiel gemäß Fig. 3a;

Fig. 4      Bandverläufe eines Valenz- und Leitungsbands gemäß einem Ausführungsbeispiel der vorliegenden Erfindung;

Fig. 5a      ein Kollektor-Dotierstoffprofil gemäß einem Ausführungsbeispiel der vorliegenden Erfindung; und

Fig. 5b      eine quantitative Darstellung eines elektrischen Felds in dem Kollektor-Bereich gemäß dem Ausführungsbeispiel von Fig. 5a.

Im folgenden werden zum besseren Verständnis der vorliegenden Erfindung physikalische Grundlagen von p-n-Übergängen anhand eines Bipolar-Transistors näher erläutert.

Zunächst wird die Abhängigkeit der Kollektordotierung auf eine Transistor-Transitfrequenz näher untersucht. Stellt man den p-n-Übergang in einem einfachen Ersatzschaltbild dar, so kann die Transitfrequenz des Transistors, die eine Schaltzeit des Bipolar-Transistors bestimmt, näherungsweise nach der folgenden Formel berechnet werden:

$$(2\pi f_T)^{-1} = \tau_f + \tau_{jc} + \frac{V_T}{I_C}(C_{jc} + C_{je}) + (r_e + r_c)C_{jc} \qquad \text{(Gl .1)}.$$

Dabei bezeichnet $f_T$ die Transitfrequenz des Bipolar-Transistors, $\tau_f$ und $\tau_{jc}$ die Basis- bzw. Kollektor-Transitzeit, d.h. diejenige Zeit, die ein Ladungsträger benötigt, um den Basis-Bereich bzw. den Kollektor-Bereich zu durchlaufen, $C_{jc}$ und $C_{je}$ eine Basis-Kollektor- bzw. Basis-Emitter-Sperrschichtkapazität, $V_T$ die Temperaturspannung kT/f, $I_C$ den Kollektorstrom, $r_e$ und $r_c$ einen elektrischen Bahn-Widerstand des Emitters bzw. des Kollektors.

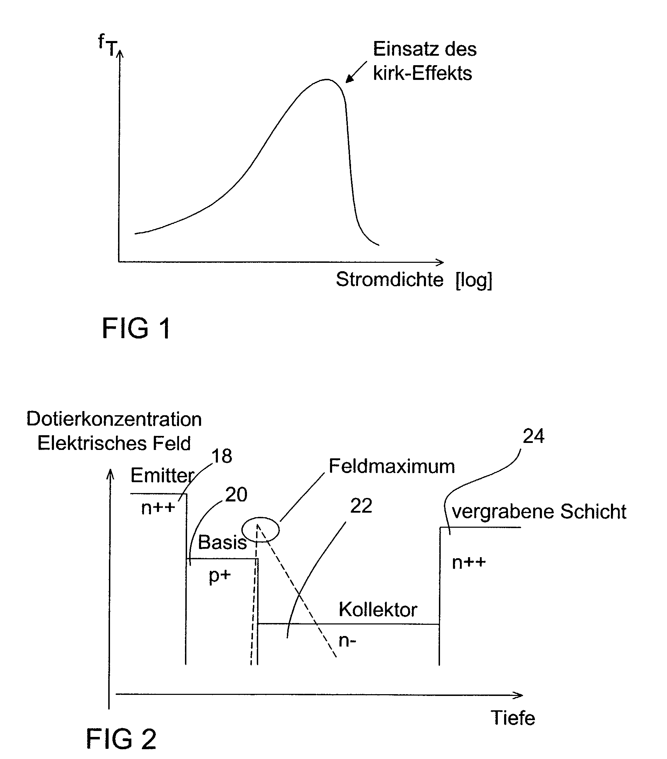

Aus Gl. 1 ist zu entnehmen, daß sich die Transitfrequenz mit zunehmendem elektrischen Strom bzw. zunehmender Stromdichte durch den Kollektor erhöht. Die in Gl. 1 angegebene Formel stellt dabei für geringe Kollektor-Stromdichten eine gute Näherung dar, für höhere Stromdichten ist jedoch der in Gl. 1 hergeleitete Zusammenhang aufgrund des auftretenden Kirk-Effekts nicht mehr gültig, wie es unter Bezugnahme auf Fig. 1 nachfolgend erklärt wird.

Fig. 1 zeigt einen typischen Verlauf der Transitfrequenz eines Hochfrequenz-Bipolar-Transistors in Abhängigkeit der Stromdichte seines Betriebsstroms. In y-Richtung ist die Transitfrequenz $f_T$ aufgetragen, während in x-Richtung die Stromdichte des Betriebsstroms dargestellt ist.

Wie es zu erkennen ist, steigt die Transitfrequenz $f_T$ entsprechend der in Gl. 1 hergeleiteten Abhängigkeit für geringe Stromdichten mit zunehmender Stromdichte des Betriebsstroms monoton an. Der Anstieg der Transitfrequenz $f_T$ setzt sich bis zu einem Maximalwert fort, nach dessen Erreichen die Transitfrequenz $f_T$ mit weiter zunehmender Stromdichte stark abnimmt.

Die Ursache für den Abfall der Transitzeit $f_T$ ergibt sich durch den Kirk-Effekt, bei dem bei Überschreiten eines elektrischen Stroms, der als Kirk-Strom bezeichnet wird, strombedingte Umladungseffekte im Kollektor einsetzen, die zu einer Potentialverschiebung und einer Aufweitung der Basislänge führen. Eine Erklärung des Kirk-Effekts findet sich beispielsweise in S.M. Sze, "Physics of Semiconductor Devices", John Wiley & Sons Inc, zweite Ausgabe, 1981.

Näherungsweise kann die Stromdichte, bei der der Kirk-Effekt einsetzt und einen Abfall der Transitfrequenz bewirkt, durch die folgende Formel beschrieben werden:

$$j_{kirk} = q v_{sat}\, N + v_{sat}\, \frac{2\varepsilon}{W_C^2}(V_{bi} + V_{CB}) \qquad \text{(Gl. 2)}$$

Dabei ist $j_{kirk}$ die Stromdichte des Kirk-Stroms, d.h. diejenige Stromdichte bei der der Kirk-Effekt einsetzt, q die Ladung der Ladungsträger, $v_{sat}$ die Sättigungsgeschwindigkeit der Ladungsträger, N die Konzentration der Kollektor-Dotierung, $W_C$ eine Dicke des Kollektor-Bereichs, $\varepsilon$ die Dielektrizitätskonstante des Kollektor-Bereichs, $V_{bi}$ die Diffusionsspannung (Built-In-Spannung) des Basis-Kollektor-Übergangs und $V_{CB}$ die Kollektor-Basis-Spannung.

Aus Gleichung 2 ist zu erkennen, daß zur Erhöhung der Stromdichte des Kirk-Stroms bei dem Entwurf eines Dotierprofils für den Kollektor-Bereich eine hohe Kollektor-Dotierung gewählt werden muß. Da durch die Verschiebung des Kirk-Stroms zu höheren Werten ein längerer monotoner Anstieg der Transitfrequenz erreicht wird, bewirkt die Erhöhung des Kirk-Stroms, daß eine höhere maximale Transitfrequenz $f_t$ erreicht wird.

Zum weiteren Verständnis der Erfindung soll nun anhand von Fig. 2 ein Verlauf des elektrischen Felds in der Basis-Kollektor-Raumladungszone eines bekannten Bipolar-Transistors erläutert und die Auswirkung des elektrischen Felds auf einen Lawinendurchbruch erklärt werden.

In Fig. 2 entspricht die x-Achse einer Richtung von dem Emitter zum Kollektor des Transistors, während die y-Achse eine Dotierkonzentration eines Dotierprofils anzeigt. Darüberhinaus ist in Fig 2. ein Verlauf des Betrags des elektrischen Felds eingezeichnet, das sich aus dem gezeigten Dotierprofil und der angelegten Spannung ergibt und für den normalen Betriebsfall in Richtung der Schichtenfolge, d.h. von dem Kollektor zu dem Emitter zeigt.

Das Dotierprofil von Fig. 2 entspricht demjenigen eines bekannten Transistors, bei dem ein Emitter 18 eine sehr hohe n-Dotierung ($n^{++}$-Dotierung), eine Basis 20 eine hohe p-Dotierung ($p^+$-Dotierung) und ein Kollektor 22 eine niedrige n-Dotierung ($n^-$-Dotierung) aufweisen. Eine vergrabene Schicht 24 mit einer $n^{++}$-Dotierung schließt ferner an den Kollektor zum Liefern eines elektrischen Anschlusses für den Kollektor an. Das gezeigte Dotierstoffprofil stellt ein stark vereinfachtes und idealisiertes Profil dar, bei dem die Dotierstoffkonzentrationen an den Grenzbereichen abrupt, d.h. vertikal abfallen.

In Fig. 2 ist ferner durch eine gestrichelte Linie der Verlauf eines Betrags des elektrischen Felds in dem Raumladungsbereich, der durch den Basis-Kollektor-Übergang erzeugt wird, gezeigt. Der Betrag der Feldstärke des elektrischen Felds steigt ausgehend von dem Kollektor in Richtung der Basis linear an, wobei in einem unmittelbaren Grenzbereich zu der Basis eine maximale Feldstärke erreicht wird. Nach dem Erreichen der maximalen Feldstärke fällt die Feldstärke weiter fortschreitend zu der Basis aufgrund der hohen Dotierstoffkonzentration der Basis und der damit verbundenen hohen Ladungsdichte in dem Basis/Kollektor Grenzbereich steil ab.

Die elektrische Feldstärke in Raumladungszonen ist von den vorliegenden Dotierkonzentrationen abhängig, wobei die elektrische Feldstärke E mit der Dichte N von ionisierten Störstellen, die aufgrund der annähernd vollständigen Ionisierung in einer Raumladungszone gleich der Dotierstoffdichte ist, gemäß der folgenden Beziehung verknüpft ist:

$$\nabla E = -\frac{N}{\varepsilon} \qquad\qquad\qquad (\text{Gl. 3}).$$

Ferner ist die elektrische Feldstärke mit der Diffusionsspannung $V_{BI}$ und der angelegten Basis-Kollektor-Spannung $V_{CB}$ gemäß der folgenden Gleichung 4 verknüpft:

$$\int\limits_{Raumladungszone} E\mathrm{dx} = V_{BI} + V_{CB} \qquad\qquad (\text{Gl. 4})$$

Die Integration des elektrischen Felds erstreckt sich dabei über die gesamte Raumladungszone, die sich durch die Diffusionsspannung $V_{BI}$ und die anliegende Kollektor-Basis-Spannung $V_{CB}$ ergibt. Aus der Verknüpfung von Gleichung 4 mit Gleichung 3 kann hergeleitet werden, daß die elektrische Feldstärke linear bis zu einem maximalen Wert zunimmt, wobei sich der maximale Feldstärkewert umgekehrt zu der Kollektor-Dotierung verhält, falls die Raumladungszone nicht an der höher dotierten vergrabenen Schicht anstößt.

Wie es bereits erklärt wurde, kann somit durch das Vorsehen einer niedrigen Dotierstoffkonzentration des Kollektors die maximale Feldstärke in dem Kollektorbereich auf einem niedrigen Wert gehalten werden und folglich eine hohe Lawinen-Durchbruchsspannung erreicht werden.

Wird nun eine so große Spannung angelegt, daß die in dem unmittelbaren Grenzbereich des Kollektors zu der Basis auftretende maximale Feldstärke den Wert erreicht, der zur lawinenartigen Erzeugung von Ladungsträgerpaaren erforderlich ist, so erhöht sich in dem Bereich der höchsten Feldstärke die Ladungsträgerzahl schlagartig, wodurch es an dem Ort der höchsten Feldstärke zu einem Lawinendurchbruch kommt, der einen ordnungsgemäßen Betrieb des Transistors nicht mehr möglich macht.

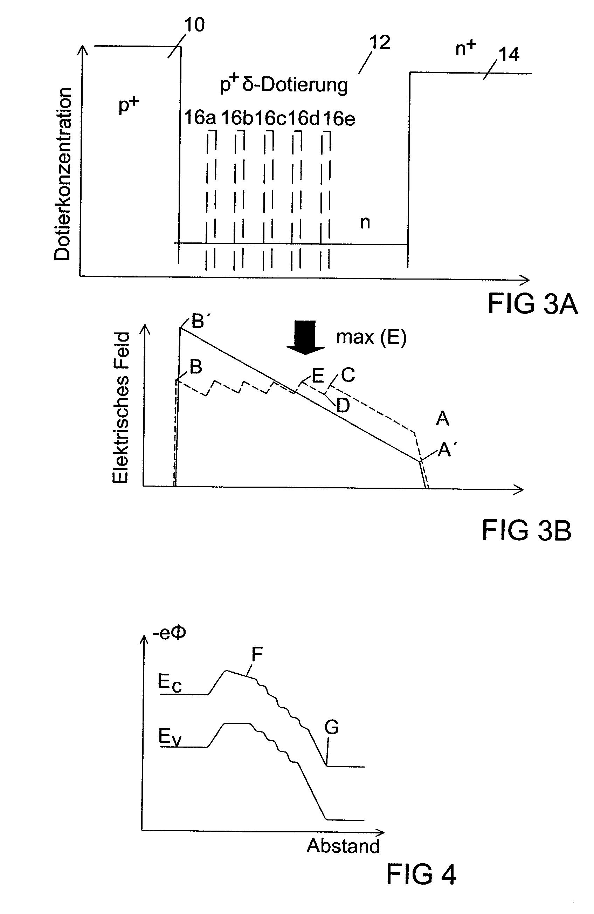

Nachdem nun für die Erfindung relevante Grundlagen näher erläutert wurden, soll nachfolgend unter Bezugnahme auf Fig. 3a ein Dotierstoffprofil gemäß einem Ausführungsbeispiel der vorliegenden Erfindung erklärt werden. Entsprechend zu einem bekannten Transistor weist das Dotierstoffprofil gemäß Fig. 3a einen Basisbereich 10 mit einer $p^+$-Dotierstoffkonzentration, einen Kollektorbereich 12, der an den Basisbereich anschließt und eine n-Grunddotierung aufweist, und eine vergrabene Schicht 14 mit einer $n^+$-Dotierstoffkonzentration auf, die an den Kollektorbereich 12 anschließt.

Im Unterschied zu bekannten Transistoren weist der Kollektorbereich 12 erfindungsgemäß Bereiche mit einer δ-Dotierkonzentration (δ-Dotierungs-Bereiche 16a-e) auf, die komplementär zu der Grunddotierung des Kollektors dotiert sind. Das heißt, wenn der Kollektor n-dotiert ist, weisen die δ-Dotierungs-Bereiche 16a-e eine p-Dotierung auf und umgekehrt. Unter einer δ-Dotierkonzentration ist dabei ein Dotierprofil zu verstehen, bei dem innerhalb eines sehr kleinen räumlichen Abstands eine hohe Konzentration von Dotieratomen vorhanden sind. Bei dem in Fig. 3a gezeigten Ausführungsbeispiel umfaßt der Kollektorbereich 12 fünf p-dotierte δ-Dotierungs-Bereiche 16a-e, die in Richtung der Schichtenfolge eine schmale Ausdehnung aufweisen. Die δ-Dotierungs-Bereiche 16a-e sind voneinander beabstandet in der Nähe des Basis/Kollektor-Grenzbereichs angeordnet. Vorzugsweise umfassen die Bereiche der Dotierkonzentrationen Werte von $10^{17}$ bis $10^{18}$ cm$^{-3}$ für die Basis, von $10^{15}$ bis $10^{17}$ cm$^{-3}$ für den Kollektor und von $10^{18}$ bis $10^{19}$ cm$^{-3}$ für die vergrabene Schicht. Ferner umfassen die δ-Dotierstoffkonzentrationen vorzugsweise einen Bereich von etwa $10^{16}$ bis $10^{18}$ cm$^{-3}$.

Zwischen dem Basisbereich 10 und dem Kollektorbereich 12 bildet sich eine Raumladungszone aus, die sich aufgrund der hohen Basis-Dotierung räumlich gesehen über einen geringen Bereich der Basis 10 erstreckt und aufgrund der niedrigeren Kollektor-Dotierung weit in den Kollektorbereich 12 erstreckt. Erfindungsgemäß sind die δ-Dotierungs-Bereiche 16a-e dabei derart angeordnet, daß bei einer typischen Betriebsspannung, die für den Transistor vorgesehen ist, die Raumladungszone eine Ausdehnung aufweist, so daß im wesentlichen sämtliche δ-Dotierungs-Bereiche 16a-e innerhalb dieser Raumladungszone liegen. Dadurch wird sichergestellt, daß diese δ-Dotierungs-Bereiche 16a-e während eines Betriebs vollständig ausgeräumt sind, so daß ein Transport der Ladungsträger durch die Raumladungszone im wesentlichen unbeeinflußt bleibt.

Fig. 3b zeigt die Wirkung der komplementär δ-Dotierungs-Bereiche 16a-e auf das elektrische Feld in der Raumladungszone. Zum Vergleich ist in Fig. 3b als eine durchgehende Linie ein Verlauf eines elektrischen Felds dargestellt, der sich für einen bekannten Transistor ergibt, der in dem Kollektorbereich eine homogene Dotierung ohne δ-Dotierungs-Bereiche aufweist. Bei dieser bekannten Halbleiterstruktur ergibt sich ein Verlauf des elektrischen Felds, bei dem die elektrische Feldstärke in der verborgenen Schicht 14 in Richtung zu der Basis zunächst stark linear ansteigt. In der Nähe eines Grenzbereichs Kollektor/verborgene Schicht ändert sich bei einem Punkt A' in der verborgenen Schicht 14 daraufhin die Steilheit des Anstiegs der elektrischen Feldstärke, wobei das elektrische Feld weiterhin linear, jedoch mit einer geringeren Steilheit, zu der Basis hin ansteigt. Dieser Anstieg wird in dem gesamten Kollektorbereich beibehalten, wobei die maximale elektrische Feldstärke für diese bekannte Halbleiterstruktur in dem Kollektorbereich 12 unmittelbar an dem Basis/Kollektor-Übergang in einem Punkt B' erreicht wird. Nach Erreichen der maximalen Feldstärke fällt dieselbe in dem Basisbereich 10 stark ab, da sich durch die hohe Dotierung der Basis in der Nähe der Grenzfläche zu dem Kollektorbereich 12 eine große Ladungsdichte aufbaut, die das starken Abfallen der elektrischen Feldstärke bewirkt.

Nachdem nun der elektrische Feldverlauf für eine bekannte Halbleiterstruktur beschrieben wurde, soll nun unter Bezugnahme auf die gestrichelte Linie in Fig. 3b der Feldverlauf der erfindungsgemäßen Halbleiterstruktur erklärt werden.

Die Wirkung der δ-Dotierungs-Bereiche 16a-e auf den elektrischen Feldverlauf läßt sich mit der Tatsache leicht verstehen, daß dieselben in der Ladungsträger-freien Raumladungszone aufgrund der ionisierten Akzeptoren jeweils Schichtbereiche mit einer negativen Ladungsdichte sind. Das durch die geladenen Akzeptoren der δ-Dotierungs-Bereiche 16a-e erzeugte elektrische Feld überlagert sich dem Feldverlauf, der durch die elektrische Raumladungszone erzeugt wird, wie es obig bei dem bekannten Transistor erklärt wurde.

Folglich ergibt sich für dieses Ausführungsbeispiel ein Verlauf des elektrischen Feldes, der in Fig. 3b als eine gestrichelte Linie gezeigt ist.

Ausgehend von der vergrabenen Schicht 14 steigt dabei das elektrische Feld in Richtung zu der Basis 10 mit der gleichen Steilheit als bei dem obig erklärten Verlauf eines bekannten Transistor auf einen Punkt A an, bei dem die elektrische Feldstärke größer als bei dem Punkt A' des bekannten Transistors ist. Daraufhin setzt in Richtung der Basis 10 bis zu einem Punkt C ein linearer Verlauf des elektrischen Felds mit dem gleichen Anstieg der Feldstärke ein. Während dieses linearen Anstiegs von dem Punkt A zu dem Punkt C weist die elektrische Feldstärke in dem Kollektorbereich 12 eine höhere Feldstärke als bei dem als durchgehende Linie gezeigten bekannten Feldverlauf auf. Dies ist zu verstehen, da die negativ geladenen δ-Dotierungs-Bereiche 16a-e ein elektrisches Feld erzeugen, das sich in diesem Bereich zu dem durch die Raumladungszone erzeugten elektrischen Feld addiert. Der Punkt C, bei dem die elektrische Feldstärke ein erstes lokales Maximum erreicht, entspricht räumlich gesehen einer ersten Seite des δ-Dotierungs-Bereichs 16e, die der vergrabenen Schicht 14 zugewandt ist.

Von dem ersten Maximum C ausgehend fällt das elektrische Feld in Richtung des Basisbereichs 10 linear ab, bis ein erstes Minimum D erreicht ist. Das Minimum D entspricht räumlich gesehen einer Mitte des δ-Dotierungs-Bereichs 16e.

Von dem ersten Minimum D steigt das elektrische Feld in Richtung zu der Basis 10 wieder an, bis ein zweites lokales Maximum E erreicht wird. Das zweite Maximum E entspricht räumlich gesehen einer ersten Seite des δ-Dotierungs-Bereichs 16d, die der vergrabenen Schicht 14 zugewandt ist, und ist gleichzeitig bei dem gezeigten Ausführungsbeispiel das absolute Maximum des Verlaufs der elektrischen Feldstärke. Die jeweilige genaue Lage des absoluten Maximums ist von dem genauen Design der Halbleiterstruktur abhängig und besitzt für das erfindungsgemäße Konzept keine entscheidende Bedeutung.

Die absolute maximale elektrische Feldstärke des erfindungsgemäßen Feldverlaufs, die bei dem gezeigten Ausführungsbeispiel in dem Punkt E erreicht wird, weist dabei einen deutlich geringeren Wert als die maximale Feldstärke des bekannten Verlaufs auf, der bei dem Punkt B' erreicht wird.

Entsprechend zu der beschriebenen Abnahme des elektrischen Felds von dem Punkt C zu dem Punkt D und einer darauffolgenden Zunahme des elektrischen Felds von dem Punkt D zu dem Punkt E ergibt sich für die weiteren Dotierbereiche 16a-c ein analoges Verhalten des elektrischen Felds, so daß das elektrische Feld in einem Bereich, in dem die $\delta$-Dotierungs-Bereiche 16a-e angeordnet sind, einen Zick-Zack-Verlauf aufweist, bei dem sich in der Mitte jedes $\delta$-Dotierungs-Bereichs ein lokales Minimum ergibt und auf einer ersten Seite jedes $\delta$-Dotierungs-Bereichs, die der vergrabenen Schicht 14 zugewandt ist, ein lokales Maximum ergibt.

Nachdem das elektrische Feld bei dem $\delta$-Dotierungs-Bereich 16a ein lokales Minimum erreicht hat, steigt das elektrische Feld in Richtung zu der Basis 10 bis zu einem Punkt B an. Der Punkt B weist gegenüber dem maximalen Feldstärkepunkt B' des bekannten Verlaufs eine deutlich geringere elektrische Feldstärke auf.

Wie es ferner aus dem vorhergehend beschriebenen Verlauf erkennbar ist, weist der Zick-Zack-Verlauf des elektrischen Felds des erfindungsgemäßen Ausführungsbeispiels in dem Bereich, in dem die $\delta$-Dotierungs-Bereiche 16a-e angeordnet sind, eine relativ geringe Veränderung auf. Vorzugsweise wird der Transistor derart entworfen, daß die Feldstärke in den $\delta$-Dotierungs-Bereichen 16a-e im Mittel der Sättigungsfeldstärke entspricht. Dies hat den Vorteil, daß durch die gering um die Sättigungsfeldstärke variierende elektrische Feldstärke die elektrischen Ladungsträger in dem gesamten Bereich der $\delta$-Dotierungs-Bereiche 16a-e annähernd eine Sättigungsgeschwindigkeit erreichen, was sich günstig auf die Transitzeiten auswirkt.

Um eine ungünstige Beeinflussung des Transports der Ladungsträger durch die Raumladungszone zu vermeiden, sind die $\delta$-Dotierungs-Bereiche 16a-e erfindungsgemäß derart in der Nähe der Basis-Kollektor-Grenzfläche angeordnet, daß dieselben bei den vorgesehenen Betriebsspannungen in der durch die Betriebsspannung erzeugten Basis-Kollektor-Raumladungszone liegen. Beispielsweise ist bei einem Ausführungsbeispiel die erfindungsgemäße Halbleiterstruktur in einem Leistungs-Hochfrequenz-Transistor vorgesehen, bei dem die vorgesehen Betriebsspannungen größer oder gleich 25 V sind.

Unter Bezugnahme auf Fig. 4 wird nun die Auswirkung der $\delta$-Dotierungs-Bereiche auf den Ladungsträgertransport in der Raumladungszone näher erläutert.

Fig. 4 zeigt den Verlauf eines Valenzbands $E_v$ und eines Leitungsbands $E_c$ für eine erfindungsgemäße Halbleiterstruktur, wie beispielsweise die Halbleiterstruktur von Fig. 3a, bei einer typischen Betriebsspannung.

Da die $\delta$-Bereiche erfindungsgemäß bei einer angelegten Betriebsspannung im wesentlichen in der Raumladungszone des Basis/Kollektor-Bereichs liegen, ergeben sich für den Bandverlauf des Valenzbands und des Leitungsbands lediglich geringfügige Störungen gegenüber einem Bandverlauf eines homogen dotierten Kollektors.

In dem Bereich der Basis/Kollektor-Raumladungszone, die in Fig. 4 zwischen den Punkten F und G gebildet ist, ergibt sich durch die $\delta$-Dotierungs-Bereiche eine Modulation des Leitungsund Valenzband. Diese Modulation wird durch das elektrische Potential der Ladungen der $\delta$-Dotierungs-Bereiche bewirkt. Ein Ladungsträgertransport wird jedoch durch die Veränderung des Bandverlaufs im wesentlichen nicht beeinflußt, da das Potentialgefälle insgesamt erhalten bleibt und die Ladungsträger auch im Bereich der flacheren Bandsteigung die Sättigungsgeschwindigkeit erreichen.

Eine nachteilige Beeinflussung des Ladungsträgertransports durch den Kollektor kann sich lediglich bei kleinen Betriebsspannungen ergeben, wenn ein Teil des Kollektorbereichs, der die $\delta$-Dotierungs-Bereiche umfaßt, nicht in einer Raumladungszone angeordnet ist, so daß die dort vorhandenen Majoritätsladungsträger eine Potentialbarriere vorfinden.

Da die erfindungsgemäße Halbleiterstruktur typischerweise vorgesehen ist, um bei hohen Betriebsspannungen betrieben zu werden, spielt dieser nachteilige Effekt bei dem vorgesehenen Betrieb mit hoher Betriebsspannung im wesentlichen keine Rolle.

Beispielsweise kann die erfindungsgemäße Halbleiterstruktur bei einem Hochfrequenz-Leistungstransistoren vorgesehen sein, der mit höheren Betriebsspannungen und Verstärker-Anwendungen im A-Betrieb mit einem gewissen Aussteuerungs-Backup betrieben wird, wodurch im Betrieb keine kleinen Kollektor-Basis-Spannungen auftreten.

Wie bei bekannten Transistoren kann bei der erfindungsgemäßen Halbleiterstruktur durch die Wahl der Grunddotierung des Kollektors das Verhalten des Transistors entsprechend einer geplanten Verwendung bestimmt werden.

Ist beispielsweise ein Betreiben bei sehr hohen Betriebsspannungen erwünscht, so kann die Grunddotierung niedrig gehalten werden, wobei jedoch im Gegensatz zu bekannten Halbleiterstrukturen bei einer vorgegebenen maximalen Betriebsspannung durch das erfindungsgemäße Vorsehen der $\delta$-Dotierungs-Bereiche in dem Kollektor eine höhere Grunddotierung gewählt werden kann, wodurch die Transitzeit auf einem niedrigeren Wert als bei einer bekannten Halbleiterstruktur gehalten werden kann.

Umgekehrt kann, wenn für ein Betriebsverhalten eine hohe Oszillationsfrequenz gewünscht ist, durch eine hohe Grunddotierung des Kollektorbereichs eine hohe Oszillationsfrequenz erreicht werden, wobei im Vergleich zu bekannten Halbleiterstrukturen durch das Vorsehen der δ-Dotierungs-Bereiche eine höher Durchbruchsspannung erreicht wird.

Folglich kann der Kompromiß, der zwischen einer Oszillationsfrequenz und einer Durchbruchsspannung eingegangen werden muß, durch die erfindungsgemäße Halbleiterstruktur wesentlich verbessert werden.

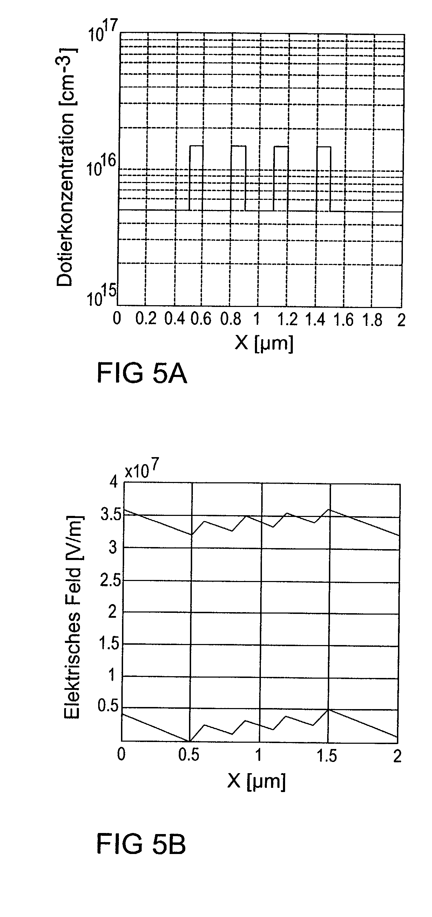

Bezugnehmend auf Fig. 5a wird nun ein quantitatives Beispiel eines Dotierkonzentration des Kollektor-Bereichs und der δ-Bereiche gegeben. In Fig. 5a gibt die x-Achse die Entfernung von der Basis/Kollektor-Grenzfläche an. Die y-Achse zeigt in einer logarithmischen Darstellung die Dotierstoff-Konzentration an. Der Kollektorbereich, der sich von der Basis/Kollektor-Grenzfläche in Richtung des elektrischen Felds über einen Bereich von 2 μm erstreckt, weist eine Grunddotierung von $5 \times 10^{15}$ cm$^{-3}$ auf. Der Kollektorbereich weist vier δ-Dotierungs-Bereiche auf. Jeder der δ-Dotierungs-Bereiche weist eine Dotierstoffkonzentration von $1,5 \times 10^{16}$ cm$^{-3}$ auf. Die vier δ-Dotierungs-Bereiche weisen jeweils eine Breite von 0,1 μm auf und sind mit einem Abstand von 0,1 μm voneinander beabstandet.

Die δ-Dotierungs-Bereiche sind in dem Kollektorbereich symmetrisch angeordnet, wobei die zwei äußeren δ-Dotierungs-Bereiche in Richtung des elektrischen Felds einen Abstand von 0,5 μm zu den jeweils begrenzenden Seiten des Basis/Kollektor-Bereichs aufweist.

Fig. 5b zeigt einen berechneten Feldverlauf für das in Fig. 5a gezeigte Dotierprofil des Kollektors bei einer anliegenden Spannung zwischen dem Kollektor und der Basis von 5 V und bei einer anliegenden Spannung zwischen dem Kollektor und der Basis von 68V, was der Durchbruchfeldstärke der Halbleiterstruktur entspricht.

Die Berechnungen wurden unter Verwendung eines eindimensionalen Modells durchgeführt, wobei für die Durchbruchsfeldstärke Werte aus S.M. Sze, "Physics of Semiconductor Devices", John Wiley & Sons Inc., 1983 angenommen wurden. In dem unteren Bereich des Diagrams ist der Feldverlauf für die Kollektor-Basis-Spannung von 5 V dargestellt. Wie es bei dem ausführungsbeispiel gemäß Fig. 3a erklärt wurde, treten bei diesem Feldverlauf entsprechend zu den vier δ-Dotierungs-Bereichen vier lokale Maxima und Minima auf, wobei eine absolute maximale Feldstärke von annähernd $0,5 \times 10^7$ V/m bei dem am weitesten von der Basis-Kollektor-Grenzfläche entfernten Maximum in einem Abstand von 1,5 μm von der Basis-Kollektor-Grenzfläche auftritt.

In dem oberen Teil des Diagramms ist der elektrische Feldverlauf für eine Spannung von 68 V zwischen Kollektor und Basis gezeigt. Diese angelegte Kollektor-Basis-Spannung entspricht einem Erreichen der Durchbruchsfeldstärke der Halbleiterstruktur gemäß Fig. 5a. Bei diesem Feldverlauf wird räumlich gesehen der Maximalwert der elektrischen Feldstärke auch bei dem Maximum mit einem Abstand von 1,5 μm von der Basis/Kollektor-Grenzfläche erreicht, wobei der Maximalwert der elektrischen Feldstärke etwa $3,7 \times 10^7$ V/m beträgt.

Um einen Vergleich mit einer bekannten Halbleiterstruktur durchführen zu können, wurde die Durchbruchsspannung für einen Transistor berechnet, der demjenigen von Fig. 5a entspricht, mit der Ausnahme, daß bei demselben der Kollektorbereich homogen mit der Grunddotierung von $5 \times 10^{15}$ cm$^{-3}$ dotiert ist und keine δ-Dotierungs-Bereiche aufweist. Die dabei berechnete Durchbruchsspannung von 57 V zeigt an, daß mit dem in Fig. 5a gezeigten Dotierstoffprofil des Kollektors eine Erhöhung der Durchbruchsspannung von 11 V erreicht wird.

Folglich kann bei gleicher Grunddotierung des Kollektors der mit der δ-Dotierung versehene Transistor gegenüber dem Transistor mit einer homogenen Kollektordotierung in höheren Spannungsbereichen betrieben werden.

Obwohl die vorliegende Erfindung lediglich durch Ausführungsbeispiele beschrieben wurde, bei denen die erfindungsgemäße Halbleiterstruktur in einem Transistor vorgesehen ist, kann das erfindungsgemäße Vorsehen von Dotierbereichen mit komplementärem Dotiertyp auch bei anderen Halbleiterbauelementen mit p-n-Übergängen erfolgen. Beispielsweise können die Dotierbereiche mit einem komplementären Dotiertyp in einem p-oder n-Bereich einer p-n-Diode angeordnet sein.

Ferner kann eine Herabsetzung der maximalen elektrischen Feldstärke und eine damit verbundene Erhöhung der Durchbruchsspannung bereits durch das Vorsehen eines einzelnen Dotierbereichs mit entgegengesetztem Ladungsträgertyp erreicht werden, wobei der Dotierbereich nicht notwendigerweise eine δ-Dotierung aufweisen muß.

**Bezugszeichenliste**

| | |
|---|---|
| 10 | Basis |
| 12 | Kollektor |
| 14 | vergrabene Schicht |
| 16a-e | δ-Dotierbereich |
| 18 | Emitter |
| 20 | Basis |
| 22 | Kollektor |
| 24 | vergrabene Schicht |

**Patentansprüche**

1. Halbleiterstruktur mit folgenden Merkmalen:

   einem ersten Bereich (10) mit einem ersten Dotiertyp und einer ersten Dotierkonzentration;

   einem zweiten Bereich (12) mit einem zweiten Dotiertyp und einer zweiten Dotierkonzentration, wobei der zweite Dotiertyp zu dem ersten Dotiertyp unterschiedlich ist, und wobei der zweite Bereich (12) an den ersten Bereich (10) angrenzt; und

   einem dritten Bereich (16a-e) mit dem ersten Dotiertyp und einer dritten Dotierkonzentration, wobei der dritte Bereich (16a-e) innerhalb des zweiten Bereichs (12) angeordnet ist, wobei der dritte Bereich (16a-e) so dimensioniert und innerhalb des zweiten Bereichs (12) angeordnet ist, daß der dritte Bereich (16a-e) im wesentlichen vollständig in einer Raumladungszone in dem zweiten Bereich (12) angeordnet ist, die entsteht, wenn eine Betriebsspannung an die Halbleiterstruktur angelegt wird.

2. Halbleiterstruktur nach Anspruch 1, bei der der zweite Bereich (12) eine Grenzfläche mit dem ersten Bereich (10) aufweist, wobei der dritte Bereich (16a-e) in der Nähe der Grenzfläche angeordnet ist.

3. Halbleiterstruktur nach Anspruch 2, bei der der dritte Bereich (16a-e) in dem zweiten Bereich (12) einen Abstand von 0,4 bis 0,6 μm von der Grenzfläche mit dem ersten Bereich (10) aufweist.

4. Halbleiterstruktur nach einem der Ansprüche 1 bis 3, bei der eine Breite des dritten Bereichs (16a-e) in der Richtung der Feldstärke der Raumladungszone geringer als eine Breite des zweiten Bereichs (12) ist.

5. Halbleiterstruktur nach einem der Ansprüche 1 bis 4, die mehrere voneinander beabstandete dritte Bereiche (16a-e) aufweist.

6. Halbleiterstruktur nach einem der Ansprüche 1 bis 5, bei der der dritte Bereich (16a-e) in der Richtung der Feldstärke der Raumladungszone eine Breite in einem Bereich von 50 bis 150 nm aufweist.

7. Halbleiterstruktur nach einem der Ansprüche 1 bis 6, bei der die Dotierkonzentration des dritten Bereichs (16a-e) höher als die Dotierkonzentration des zweiten Bereichs (12) ist.

8. Halbleiterstruktur nach Anspruch 7, bei der die Dotierkonzentration des zweiten Bereichs (12) in einem Bereich von $10^{15}$ bis $10^{16}$ cm$^{-3}$ liegt und die Dotierkonzentration des dritten Bereichs (16a-e) in einem Bereich von $10^{16}$ bis $10^{17}$ cm$^{-3}$ liegt.

9. Transistor, bei dem die Basis-Kollektor-Halbleiterstruktur eine Halbleiterstruktur nach einem der Ansprüche 1 bis 8 ist, wobei der erste Bereich (10) die Basis des Transistors, der zweite Bereich (12) der Kollektor des Transistors und die Betriebsspannung die Kollektor-Basis-Spannung ist.

10. Transistor nach Anspruch 9, bei dem der Transistor ein Leistungstransistor ist.

11. Transistor nach Anspruch 9 oder 10, bei dem der Transistor ein Hochfrequenztransistor ist.

12. Transistor nach einem der Ansprüche 9 bis 11, bei dem die Kollektor-Basis-Spannung größer oder gleich 25 V ist.

13. Verfahren zum Herstellen eines Transistors mit folgenden Merkmalen:

    Bereitstellen eines Substrats;

    Erzeugen eines Basisbereichs (10) mit einem ersten Dotiertyp und einer ersten Dotierkonzentration auf dem Substrat;

    Erzeugen eines Kollektorbereichs (12) mit einem zweiten Dotiertyp und einer zweiten Dotierkonzentration, wobei der zweite Dotiertyp zu dem ersten Dotiertyp unterschiedlich ist und der Kollektorbereich (12) an den Basisbereich (10) angrenzt; und

Erzeugen eines dritten Bereichs (16a-e) in dem Kollektorbereich (12) mit dem ersten Dotiertyp und einer dritten Dotierkonzentration, wobei der dritte Bereich (16a-e) derart dimensioniert und in dem Kollektorbereich angeordnet ist, daß der dritte Bereich (16a-e) im wesentlichen vollständig in einer Raumladungszone in dem Kollektorbereich angeordnet ist, die entsteht wenn eine Betriebsspannung an den Transistor angelegt wird.

14. Verfahren zum Betreiben eines Transistors mit folgenden Schritten:

Bereitstellen eines Transistors nach einem der Ansprüche 9 bis 12;

Anlegen einer Kollektor-Basis-Spannung, so daß der dritte Bereich (16a-e) im wesentlichen vollständig in der durch die Kollektor-Basis-Spannung erzeugten Raumladungszone liegt.

FIG 1

FIG 2

FIG 3A

FIG 3B

FIG 4

FIG 5A

FIG 5B